Europäisches Patentamt

(19) European Patent Office

Office européen des brevets

(11) Publication number: **0 327 111 B1**

(12) **EUROPEAN PATENT SPECIFICATION**

(45) Date of publication of patent specification:
**12.06.91 Bulletin 91/24**

(21) Application number: **89101933.3**

(22) Date of filing: **03.02.89**

(51) Int. Cl.⁵: **H01S 3/16, C01B 31/06, C30B 33/04**

## (54) Diamond laser and method of producing the same and method of operating the same.

(30) Priority: **05.02.88 JP 26372/88**

(43) Date of publication of application:
**09.08.89 Bulletin 89/32**

(45) Publication of the grant of the patent:
**12.06.91 Bulletin 91/24**

(84) Designated Contracting States:
**DE FR GB**

(56) References cited:
**WO-A-86/03347**
**REP. PROG. PHYS, vol. 42, no. 10, 1979, pages 1605-1659, The Institute of Physics, GB; J. WALKER: "Optical absorption and luminescence in diamond"**

(73) Proprietor: **SUMITOMO ELECTRIC INDUSTRIES, LTD.**
**5-33, Kitahama 4-chome, Chuo-ku**
**Osaka-shi, Osaka 541 (JP)**

(72) Inventor: **Shuichi, Satoh c/o Itami Works of Sumitomo Electric Ind.,Ltd 1-1 Koyakita 1-chome**
**Itami-shi Hyogo-ken (JP)**
Inventor: **Kazuwo, Tsuji c/o Itami Works of Sumitomo Electric Ind, Ltd 1-1 Koyakita 1-chome**
**Itami-shi Hyogo-ken (JP)**
Inventor: **Takeru, Nakashima c/o Itami Works of Sumitomo Electric Ind., Ltd 1-1 Koyakita 1-chome**
**Itami-shi Hyogo-ken (JP)**

(74) Representative: **Kirschner, Klaus Dieter et al Patentanwälte Herrmann-Trentepohl Kirschner Grosse Bockhorni Forstenrieder Allee 59**
**W-8000 München 71 (DE)**

## Description

BACKGROUND OF THE INVENTION

Field of the Invention

The present invention relates to a diamond laser and a method of producing the same and a method of operating the same and particularly it relates to a diamond laser capable of varying wavelength in the near infrared region and a method of producing the same and a method of operating the same.

Background Art

As for conventional diamond lasers, there is an example, as described in US-A-4638484 or Optics Letters, Vol. 10, p 481 (October 1985), in which pulsed laser action is effected at 530 nm using H3 color centers. In this laser, natural diamond is used.

There has been no example which effects or suggests laser action using H2 color centers. However, properties of H2 centers are described, in Reports on Progress in Physics, Vol. 42, pp. 1605-1659 (1979). It is reported therein that H2 color centers are not formed in type Ib diamond and that they coexist with H3 centers, and have low absorption in natural type Ia diamond.

A conventional method of forming H2 color centers, as described in "Optical Absorption and Luminescence in Diamond", printed in Reports on Progress in Physics, Vol. 42, p. 1648 (1979), comprises the step of heat-treating, at 627°C, natural Ia type diamond containing not less than $10^{19}$ nitrogen atoms/cm$^3$. In this case, heating at 227-327°C in dark places increases H2 centers but decreases H3 centers. Further, with the conventional method, it is impossible to form H2 centers from type IIa and type Ib diamonds.

In this connection, lasers which are capable of varying wavelengths in the near infrared region include the F center laser using alkali halide single crystals and the dye laser.

The lasing wavelength of said F center laser is in the ranges of 1400-1600 nm and 2200-3300 nm in the range of 1000-1400 nm laser action is impossible. The wavelength range in which the dye laser oscillates continuously is 330-1050 nm and 1100-1200 nm. The range in which the laser output power is high is 400-800 nm, and the output power in the near infrared region is very low.

Thus, the conventional near infrared lasers have the following drawbacks :

i) in the region of 1000-1400 nm, wavelength cannot be varied ;

ii) in a dye laser of which tuning range is in 1100-1200 nm, the output power is very low.

## SUMMARY OF THE INVENTION

An object of the present invention is to provide a diamond laser which uses diamond as a laser medium heretofore not used and which produces high output power and is capable of varying wavelengths in the near infrared region. Further, the invention also makes it possible to provide a small-sized high output power laser capable of varying wavelength.

In a diamond laser according to the invention, the maximum optical density of H2 centers in the direction of the pumping light in a synthetic diamond is the range of 0.01-4 and laser action is effected in the range of 1000-1400 nm by external pumping light at 650-950 nm.

A first method of producing said diamond laser according to the invention comprises the steps of subjecting synthetic type Ib diamond whose nitrogen concentration is $1 \times 10^{17} - 8.5 \times 10^{19}$ atoms/cm$^3$, to electron irradiation to a dose of not less than $5 \times 10^{17}$ electrons/cm$^2$, and heat-treating it in the temperature range of 1400-1850°C in a vacuum at not more than 1 Torr or in an inert gas atmosphere.

A second method of producing said diamond laser according to the invention comprises the steps of subjecting synthetic type Ib diamond whose nitrogen concentration is $1 \times 10^{17} - 8.5 \times 10^{19}$ atoms/cm$^3$, to electron irradiation to a dose of $5 \times 10^{17}$ electrons/cm$^2$, and heat treating it under ultrahigh pressure and high temperature conditions at not less than 3.0 GPa and not less than 1500°C.

A method of operating said diamond laser comprises the step of using laser as said external pumping light. In this case, a single or plurality of semiconductor lasers may be used for said external pumping light.

<Description of Laser>

For laser action using H2 centers, it is important that the maximum value of optical density of H2 centers be between 0.01 and 4. Here, the optical density is given by the following formula.

$$\text{(Optical density)} = 1n \, (I_0/I)$$

where $I_0$ is incident light intensity and $I$ is transmitted light intensity. In this case, when there is no absorption, $I = I_0$. This optical density depends on the thickness of crystals. As a result, even if the material is the same, optical density differs with length.

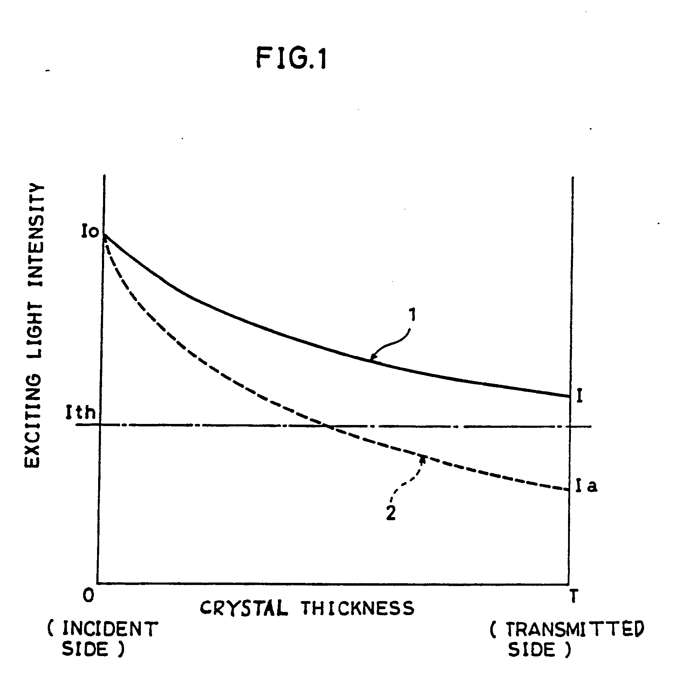

Fig. 1 shows a pumping light intensity distribution in a crystal with a thickness $\underline{T}$ when pumping light with $I_0$ falls on the crystal. A solid line 1 indicates a typical distribution in which the optical density is within the range of the invention, and a broken line 2 indicates a comparative example in which the optical density is greater than the limit value. $I$ and $Ia$ indicate their respective intensities on the transmission side. Ith indicates the threshold value required for laser oscillation.

As is clear from Fig. 1, in order to obtain a pumping light distribution in which the intensity is higher than Ith, the lower the optical intensity, the better. If the optical intensity is too high, the exciting light intensity becomes lower than Ith, which is necessary for laser action, in some crystals. Therefore, in such locations, laser action does not occur. To ensure that laser action occurs throughout the crystal, it is important that the pumping light intensity be not less than Ith throughout the crystal. To this end, the optical density must be not more than 4. On the other hand, setting the optical density at too low a value means that the color center concentration decreases. If the color center concentration is too low, stimulated emission does not occur, nor does laser action. That is, if the optical density of H2 centers is less than 0.01, laser action does not occur. In addition, as can be seen from the foregoing description, said optical density value becomes important when it is in the same direction as the incident light (pumping light).

<Description of Method of Production of H2 Center in Diamond>

To produce H2 center in diamond according to the invention, the following arrangement is important :

(1) synthetic type Ib diamond whose nitrogen concentration is $1 \times 10^{17} - 8.5 \times 10^{19}$ atoms/cm$^3$ is used ;

(2) Electron irradiation to a dose of not less than $5 \times 10^{17}$ electrons/cm$^2$ is applied to said diamond.

Further, it is necessary to apply a heat treatment. There are two methods of heat treating diamonds which follow.

(3) Heating is effected at pressures less than 1 Torr (1 Torr = $1.333 \times 10^2$Pa) or in an inert gas atmosphere in the temperature range of 1400-1850°C.

(4) Heat treatment is effected at ultrahigh pressures not less than 3 GPa and at high temperature at not less than 1500°C.

Therefore, there are two production methods : a method comprising said arrangement (1), (2) and (3) and a method comprising said arrangement (1), (2) and (4). These methods differ greatly from said conventional method in the following points :

i) The type Ib diamond in which it has heretofore been believed to be impossible to produce H2 color centers is used ;

ii) heat treating temperature is as high as 1400°C ;

iii) diamond crystal whose nitrogen concentration is $1 \times 10^{17} - 8.5 \times 10^{19}$ atoms/cm$^3$ is used.

The respective arrangements will now be described.

(On the arrangement of (1))

In the case where the nitrogen concentration in diamond is not more than $1 \times 10^{17}$ atoms/cm$^3$, H2 center will be formed with its optical density not more than 0.01. In the case of not less than $8.5 \times 10^{19}$ atoms/cm$^3$, the optical density will be not less than 4. As for diamond crystal, small single crystals by the film growth method can be available, but it is preferable to use large-sized single crystals with high purity by the temperature gradient method.

(On the arrangement of (2))

The present invention is characterized by a large amount of electron beam irradiation. In the case of high nitrogen concentration, color centers can be formed by using a relatively small amount of electron irradiation, but if the nitrogen is small, a large amount of electron irradiation is needed. The lower limit is $5 \times 10^{17}$ electrons/cm$^2$. Preferably, it is $1 \times 10^{18} - 1 \times 10^{23}$ electrons/cm$^2$. In the case of not less than $1 \times 10^{23}$ electrons/cm$^2$, the defects caused by electron beams can no longer be eliminated by the annealing described above in (3) and (4). It is preferable that the electron irradiation energy be in the range of 0.5-5 MeV.

(On the arrangement of (3) and (4))

H2 centers are formed by heat treatment. Temperature condition is important ; in a vacuum, not less than 1400°C is needed. However, if the temperature is not less than 1850°C, phase transformation takes place, so diamond changing into graphite. Unless heat treatment is effected at pressures not more than 1 Torr, the diamond surface is graphitized. In this case, inert gas, such as Ar or $H_2$, may be used instead of vacuum.

In the case where H2 centers are formed at ultrahigh pressure, heat treatment at not less than 1500°C is needed. At pressure of 3.0 GPa applied, diamond will not be graphitized even if heat treatment is effected at temperatures up to 2500°C.

H2 centers are formed in the early stage of such annealing, and thereafter H2 centers are decreased. Therefore, by suitably selecting temperature condition and time for this annealing, the concentration of H2 centers can be controlled.

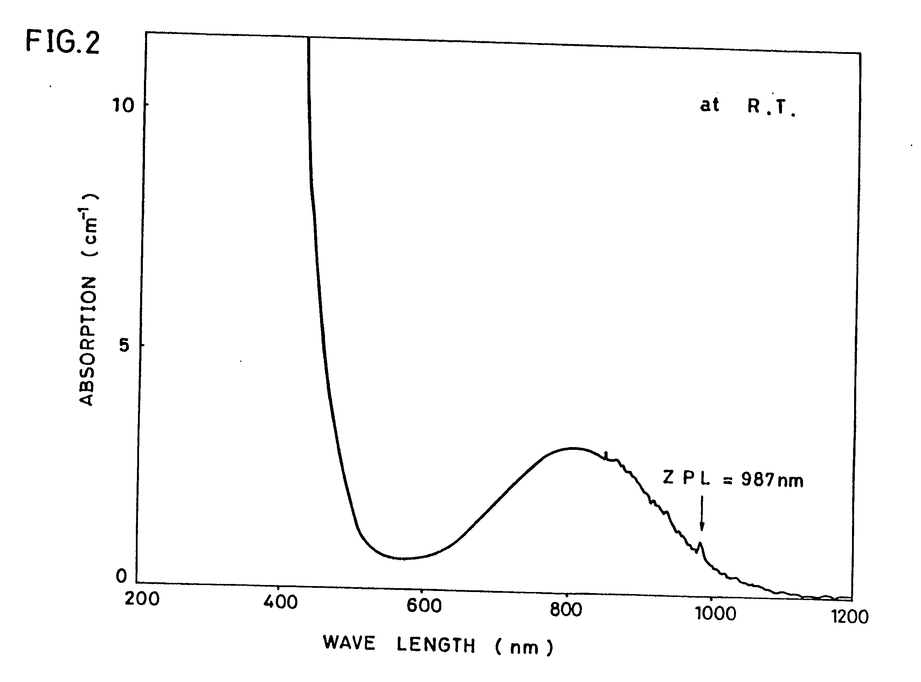

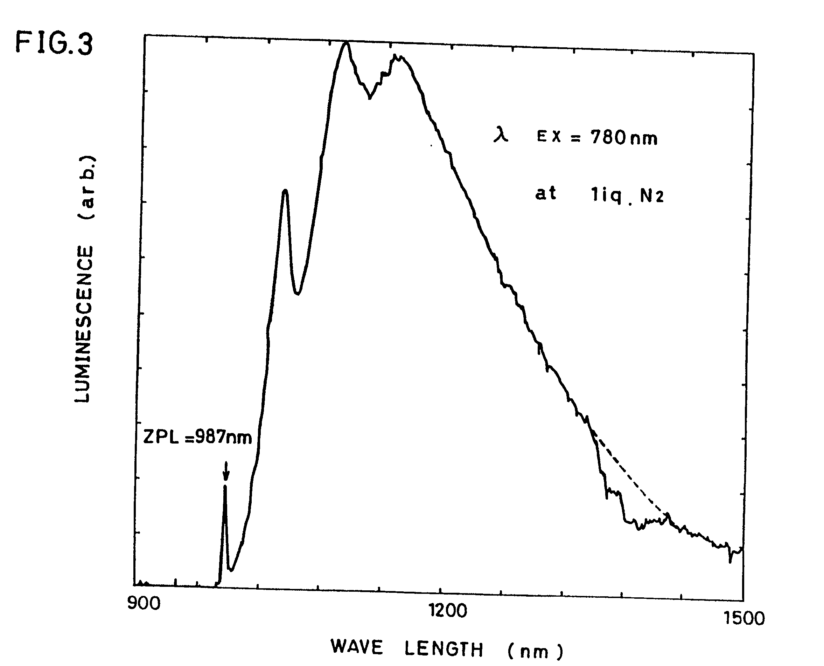

For example, the absorption and emission spectrum of H2 centers formed by the above method (1), (2), (4) are shown in Figs. 2 and 3. In emission spectrum measurement, a semiconductor laser with a wavelength of 780 nm was used as pumping light. It has been found that these centers have zerophonon line (ZPL) at a wavelength of 987 nm.

The absorption of H2 centers lies in the range of 600-992 nm. The absorption peak lies at 800 nm, and it is in the range of $800 \pm 150$ nm that pumping light works efficiently.

The use of laser pumping light provides high conversion efficiency. If a semiconductor laser (for example, a laser with wavelength at 780 nm) is used as an pumping light source, it is possible to decreases the size. To obtain a small-sized high output power laser, it is preferable to use a plurality of lasers disposed in array. Further, to vary the wavelengths in the range of 1000-1400 nm, a wavelength tuning element, such as grating, prism or etalon will be inserted in a resonator or in an optical path.

<Effect of the Invention>

As described above, according to the invention, H2 centers which have heretofore been impossible to form in type Ib diamond can be formed with satisfactory reproducibility.

Further, the use of a laser according to the invention enables laser action to be effected in the wavelength range of 1000-1400 nm.

The use of a semiconductor laser as an external pumping light source makes it possible to provide a small-sized high output power laser capable of varying the wavelength.

In addition, said laser is effective if utilized for spectroanalysis, distance measurement, fine machining or other purposes.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a graph showing the relation between the element thickness of a laser crystal and pumping light intensity ;
Fig. 2 is a graph showing absorption spectrum of H2 centers at room temperature ;
Fig. 3 is a graph showing emission spectrum of H2 center ; at the liquid nitrogen temperature
Fig. 4 is a schematic view of a laser system ;
Fig. 5 is a schematic view of a laser system using semiconductor laser as pump source.

BRIEF DESCRIPTION OF THE PREFERRED EMBODIMENTS

Example 1

This example is an embodiment of the production method described in claim 2.

9 pieces of type Ib diamonds synthesized by the temperature gradient method were prepared. These diamonds were cut into a size of 4 mm × 4 mm × 2 mm. The nitrogen concentrations were in the range of $5 \times 10^{16} - 1.7 \times 10^{20}$ atoms/cm$^3$. These samples were subjected to electron irradiation to a dose of $1 \times 10^{17} - 1 \times 10^{23}$ electrons/cm$^2$ with an accelerating voltage of 3 MeV. Further, annealing was performed in the range of 1200-1900°C in a vacuum of 1 Torr. The annealing lasted for 5 hours. The results obtained are shown in Table 1.

Annealing was also carried out in an N$_2$ gas atmosphere dried through a dry column, instead of in a vacuum, and the same results were obtained.

Table 1

| Sample No. | 1 | 2 | 3 | 4 | 5 | 6 | 7 | 8 | 9 |
|---|---|---|---|---|---|---|---|---|---|
| Optical density | 0.005 | approximately 0 | approximately 0 | 0.01 | 0.3 | 4 | 6 | approximately 0 | impossible to measure |
| Nitrogen concentration (atoms/cm$^3$) | $5 \times 10^{16}$ | $5.1 \times 10^{18}$ | $5.1 \times 10^{18}$ | $1 \times 10^{17}$ | $5.1 \times 10^{18}$ | $8.5 \times 10^{19}$ | $1.7 \times 10^{20}$ | $1.7 \times 10^{19}$ | $1.7 \times 10^{19}$ |
| Amount of electron irradiation (electrons/cm$^2$) | $1 \times 10^{18}$ | $1 \times 10^{17}$ | $1 \times 10^{18}$ | $5 \times 10^{17}$ | $1 \times 10^{19}$ | $1 \times 10^{21}$ | $1 \times 10^{21}$ | $1 \times 10^{19}$ | $1 \times 10^{21}$ |
| Annealing temperature ($^{\circ}$C) | 1600 | 1600 | 1200 | 1400 | 1600 | 1850 | 1850 | 1850 | 1900 |
| Laser action | absent | absent | absent | present | present | present | absent | absent | absent |
| | Comparative example | Comparative example | Comparative example | Example of invention | Example of invention | Example of invention | Comparative example | Comparative example | Comparative example |

EP 0 327 111 B1

In the No. 9 sample, optical measurement was tried but failed because this diamond changed into graphite and turned to black.

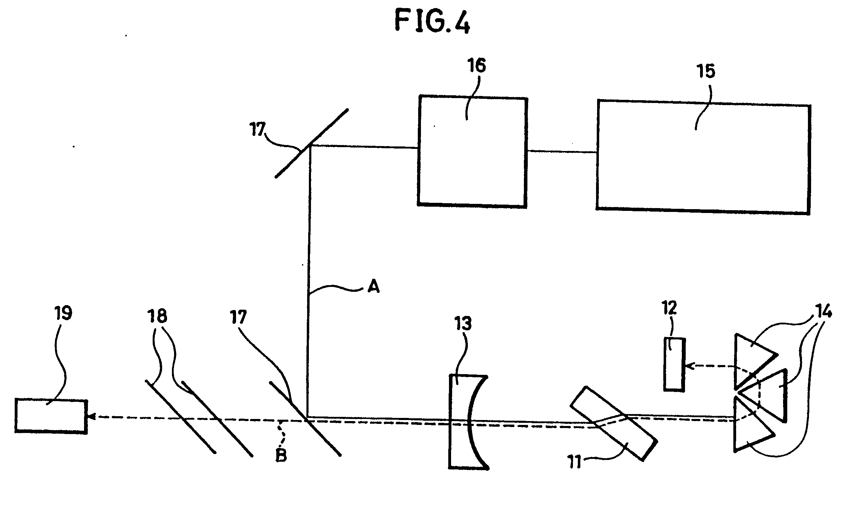

In this experiment, the nitrogen concentration of diamonds was estimated from an absorption coefficient of 1130 cm⁻¹ by infrared spectral analysis. Further, optical density was measured by an instrument for spectroanalysis in visible region. Laser action was effected by using a laser system shown in Fig. 4. In Fig. 4, the numeral 11 denotes a laser crystal ; 12 denotes a total reflection mirror ; 13 denotes a translucent mirror ; 14 denotes a prism, 15 denotes an argon ion laser ; 16 denotes a dye laser ; 17 denotes mirror for changing the optical path ; 18 denotes a filter ; and 19 denotes a measuring instrument. The solid line A denotes pumping light and broken line B denotes laser light.

## Example 2

This example is an embodiment of the production method defined in claim 3.

As rough diamonds, 4 pieces of Ib type diamonds made by the temperature gradient method was prepared. These diamonds were cut into a size of 4 mm × 4 mm × 2 mm. The nitrogen concentration was in the range of $5 \times 10^{18}$ atoms/cm³. These samples were subjected to electron irradiation to a dose of $1 \times 10^{19}$ electrons/cm² with accelerating voltage of 2 MeV. Further, 15 hours of annealing was carried out at varying temperature in the range of 1300-2500°C in a ultrahigh pressure of 3.0 GPa.

The results obtained are shown in Table 2.

Table 2

| Sample No. | 11 | 12 | 13 | 14 |
|---|---|---|---|---|
| Optical density | 0.005 | 0.2 | 2.5 | 1.6 |
| Ultrahigh pressure high temperature annealing temperature (°C) | 1300°C | 1500°C | 2000°C | 2500°C |
| Laser action | absent | present | present | present |
| | Comparative Example | Example of invention | Example of invention | Example of invention |

In this experiment, measurements of the nitrogen concentration in diamonds, optical density and laser action were made by the same methods as in Example 1 described above.

## Example 3

The No. 5 sample prepared in Example 1 was arranged with a Brewster angle as shown at the numeral 11 in Fig. 4. The total reflection mirror 12, translucent mirror 13 and prism 14 were arranged as shown in Fig. 4 to constitute a resonator. As a pumping light source, use was made of an argon ion laser 15 and a dye laser 16. The argon ion laser 15 was used for pumping the dye laser 16. Since the dye laser 16 was capable of varying the wavelength, the laser light from the dye laser 16 was used as pumping light for samples.

When the pumping light A was applied to the sample 11 subsequently to optical path deflection by the mirror 17, the laser light is amplified in the resonator constituted of the translucent mirror 13, total reflection mirror 12 and prism 14, and laser light was emitted. Stray light due to pumping light was cut by a filter 18, and the output and wavelength were measured by a power meter or wavelength measuring instrument 19.

When the pumping wavelength was varied to 500-1000 nm, laser action occurred in the range of 1000-1400 nm. It was in the region of 650-950 nm that laser intensity was high. Further, by setting the pumping wavelength of the dye laser 16 at 800 nm and moving the total reflection mirror 12, laser action occurred continuously in the region of 1000-1400 nm.

Example 4

This example is an embodiment of claim 5.

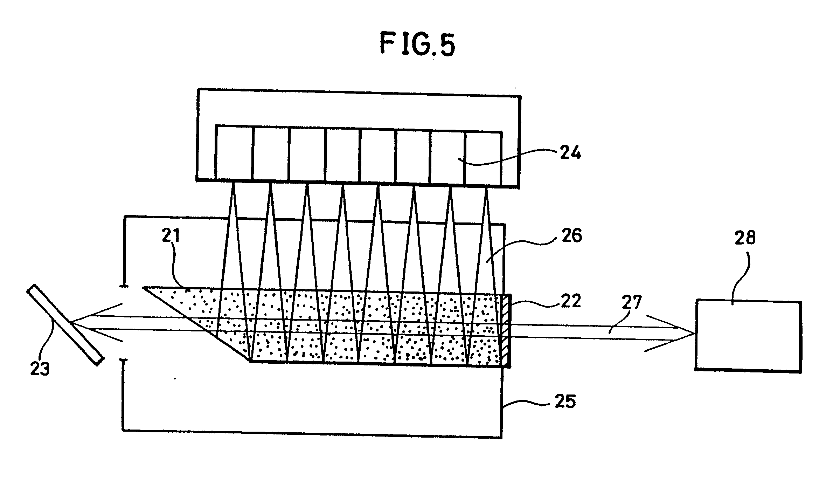

In this example, a laser apparatus shown in Fig. 5 was used. In the laser apparatus pumped by semiconductor laser shown in Fig. 5, the numeral 23 denotes a grating ; 24 denotes a semiconductor laser array ; 25 denotes a condenser ; 26 denotes exciting light ; 27 denotes laser light ; and 28 denotes a measuring instrument. Here, eight semiconductor lasers whose wavelength is 780 nm were used to form the semiconductor array 24.

First, to provide the laser crystal 21 shown in Fig. 5, an synthetic type Ib diamond was cut into a rod form having a diameter of 2 mm and a length of 10 mm, one longitudinal end surface being cut at the Brester angle. The nitrogen concentration of the sample was $3.5 \times 10^{18}$ atoms/$cm^3$. The sample was subjected to electron irradiation to a dose of $1 \times 10^{19}$ electrons/$cm^2$ with 3 MeV. Thereafter, ultrahigh pressure high temperature annealing at 3.0 GPa and 1800°C was carried out. The surface of the sample was made optical polish and then the vertical end surface was coated with a translucent film 22. Thereby, the crystal 21 shown in Fig. 5 was obtained.

Further, the crystal 21 was placed in the condenser 25 and the pumping light 26 was incident on the crystal 21 through a hole in the condenser 25.

Wavelength selection was effected by adjusting the grating 23, whereby laser action occurred in the range 1000-1400 nm. In addition, the output power and laser wavelength were measured by a power meter or wavelength measurement 28.

## Claims

1. A diamond laser wherein the maximum optical density of H2 centers in synthetic diamond in the direction of the pumping light is in the range of 0.01-4 and laser action is effected in the range of 1000-1400 nm by external pumping light at 650-950 nm.

2. A method of producing H2 centers in diamond used in the diamond laser defined in claim 1, comprising the steps of :

using a synthetic type Ib diamond whose nitrogen concentration is $1 \times 10^{17} - 8.5 \times 10^{19}$ atoms/$cm^3$,

subjecting said diamond to electron irradiation to a dose of not less than $5 \times 10^{17}$ electrons/$cm^2$, and

heat-treating is in the temperature range of 1400-1850°C in a vacuum of not more than $1.333 \times 10^2$ Pa (1 Torr) or in an inert gas atmosphere.

3. A method of producing H2 centers in diamond used in the diamond laser defined in claim 1, comprising the steps of :

using a synthetic type Ib diamond whose nitrogen concentration is $1 \times 10^{17} - 8.5 \times 10^{19}$ atoms/$cm^3$,

subjecting said diamond to electron irradiation to a dose of not less than $5 \times 10^{17}$ electrons/$cm^2$, and

heat treating it under ultrahigh pressure and high temperature conditions at not less than 3.0 GPa and not less than 1500°C.

4. A method of controlling a laser emission of a laser emitting diamond comprising H2 centers with a maximum optical density in the direction of a pumping light within the range of 0.01 to 4 and a lasing ability in the range of 1000 to 1400 nm in response to an external pumping light having a wavelength within the range of 650 to 950 nm, said method comprising the steps of

a. exposing said laser emitting diamond to laser light as said external pumping light, and

b. varying the emitted laser wavelength in the range of 1000 to 1400 nm.

5. A method as set forth in claim 4, using a single or plurality of semiconductor lasers for said external pumping light.

## Revendications

1. Laser à diamant dans lequel la densité optique maximale des centres H2 dans un diamant synthétique dans la direction de la lumière de pompage est comprise entre 0,01 et 4 et l'action laser est réalisée dans la plage 1000-1400 nanomètres au moyen d'une lumière de pompage externe à 650-950 nanomètres.

2. Méthode pour produire des centres H2 dans un diamant utilisé dans le laser à diamant défini dans la revendication 1, comprenant les opérations qui consistent à :

utiliser un diamant à Ib du type synthétique dont la concentration en azote est comprise entre $1 \times 10^{17}$ et $8,5 \times 10^{19}$ atomes/$cm^3$,

soumettre ledit diamant à un rayonnement électronique jusqu'à une dose non inférieure à $5 \times 10^{17}$ élec-

trons/cm2, et à

traiter thermiquement celui-ci dans l'intervalle de températures 1400-1850°C dans un vide de pression non supérieure à 1,333 × 10² Pa (1 Torr) ou dans une atmosphère de gaz inerte.

3. Méthode pour produire des centres H2 dans un diamant utilisé dans le laser à diamant défini dans la revendication 1, comprenant les opérations qui consistent à :

utiliser un diamant à Ib du type synthétique dont la concentration en azote est comprise entre $1 \times 10^{17}$ et $8,5 \times 10^{19}$ atomes/cm³,

soumettre ledit diamant à un rayonnement électronique jusqu'à une dose non inférieure à $5 \times 10^{17}$ électrons/cm2, et a

traiter thermiquement celui-ci à très haute pression et dans des conditions de température élevée à au moins 3,0 Gpa et au moins 1500°C.

4. Méthode pour commander une émission laser d'un diamant à émission laser comprenant des centres H2 dont la densité optique maximale dans la direction de la lumière de pompage est comprise entre 0,01 et 4 et dont la capacité d'émission laser est dans la plage 1000 à 1400 nanomètres en réponse à une lumière de pompage externe ayant une longueur d'onde comprise dans la gamme de 650 à 950 nanomètres, ladite méthode comprenant les opérations qui consistent à :

a. exposer ledit diamant à émission laser à une lumière laser en tant que ladite lumière de pompage externe, et à

b. faire varier la longueur d'onde de lumière laser émise dans la plage de 1000 à 1400 nanomètres.

5. Méthode selon la revendication 4, mettant en oeuvre un seul ou un ensemble de lasers à semiconducteur pour obtenir ladite lumière de pompage externe.

## Ansprüche

1. Diamant-Laser, bei dem die maximale optische Dichte von H2-Zentren in synthetischem Diamant im Bereich von 0,01-4 liegt und die Laseraktion im Bereich von 1000-1400 nm durch externes Pump-Licht bei 650-950 nm bewirkt wird.

2. Verfahren zum Erzeugen von H2-Zentren in in Diamant-Lasern nach Anspruch 1 verwendetem Diamant, welches die Schritte umfaßt :

– Verwendung eines synthetischen Diamanten des Ib-Typs, dessen Stickstoff-Konzentration $1 \times 10^{17} - 8,5 \times 10^{19}$ Atome/cm³ beträgt,

– Bestrahlung des Diamanten mit Elektronen bis zu einer Dosis von nicht weniger als $5 \times 10^{17}$ Elektronen/cm2, und

– Wärmebehandlung desselben bei einem Temperaturbereich von 1400-1850°C in einem Vakuum von nicht mehr als $1,333 \times 10^2$ Pa (1 Torr) oder in einer Inertgasatmosphäre.

3. Verfahren zum Erzeugen von H2-Zentren in in Diamant-Lasern nach Anspruch 1 verwendetem Diamant, welches die Schritte umfaßt :

– Verwendung eines synthetischen Diamanten des Ib-Typs, dessen Stickstoff-Konzentration $1 \times 10^{17} - 8,5 \times 10^{19}$ Atome/cm³ beträgt,

– Bestrahlen des Diamanten mit Elektronen bis zu einer Dosis von nicht weniger als $5 \times 10^{17}$ Elektronen/cm2, und

– Wärmebehandlung desselben unter Ultrahochdruck- und hohen Temperaturenbedingungen bei nicht weniger als 3,0 GPa und nicht weniger als 1500°C.

4. Verfahren zum Steuern einer Laseremission eines einen Laserlicht emittierenden Diamanten, der H2-Zentren mit einer maximalen optischen Dichte in der Richtung des Pumplichts im Bereich von 0,01 bis 4 und ein Laservermögen von 1000 bis 1400 nm in Antwort auf ein externes Pumplicht mit einer Wellenlänge im Bereich von 650 bis 950 nm hat, wobei das Verfahren die Schritte aufweist :

a) Aussetzen des Laserlicht emittierenden Diamanten einem Laserlicht als externem Pumplicht und

b) Variieren der emittierten Laserwellenlänge im Bereich von 1000 bis 1400 nm.

5. Verfahren nach Anspruch 4, wobei ein einziger Halbleiterlaser oder eine Vielzahl von Halbleiterlasern als externes Pumplicht verwendet wird.

# FIG.1

FIG.2

FIG.3

LUMINESCENCE (arb.)

$\lambda$  EX = 780nm

at  1iq.N2

ZPL =987nm

WAVE LENGTH (nm)

900          1200          1500

EP 0 327 111 B1

# FIG.4

EP 0 327 111 B1

FIG.5